# EUROPEAN PATENT APPLICATION

(11) **EP 1 020 929 A1**
(43) Date of publication of application: **19.07.2000**
(21) Application number: 00200156.8
(22) Date of filing: 17.01.2000
(51) Int. Cl.: H01L 31/042

(54) **Assembly with photovoltaic panel for a roof**

(30) Priority: 15.01.1999 NL 1011047
(71) Applicant: UBBINK NEDERLAND B.V., NL-6984 AA Doesburg (NL)
(72) Inventor: van Schellebeek, Dirk Johannes, 6715 LK Ede (NL); Ham, Michiel, c/o Ubbink Nederland B.V., 6984 AA Doesburg (NL); Theunissen, Verius Leo Antonius, 6921 CX Duiven (NL)
(74) Representative: Ferguson, Alexander

(57) **Abstract**

Assembly of a PV panel having a surface-area of several roof tiles, and a carrier for it, the carrier being provided with means for positioning in a tiled roof of a building and water-repellent connection to said tiled roof and extending like a plate underneath the PV panel, the plate underneath the PV panel being provided with profilings in order to form ventilation passages.

## Description

The invention relates to an assembly of a PV panel and a carrier for it, destined to be placed on the roof of a building for the conversion of solar energy.

It is known to arrange PV panels, that means panels provided with solar cells, on an inclined tiled roof of an existing house by attaching the PV panel to the roof tiles. Said attachment requires a lot of effort and expertise. The PV panel projects upwards from the upper surface of the tiled roof, as a result of which not only the aesthetic value of the roof deteriorates but also situates the PV panel rather vulnerably.

According to another known manner of installation the PV panel is laid at a location in a tiled roof, where prior to that an area of tiles was removed. The PV panel is then directly attached to the roof, recessed between the roof tiles surrounding it. The PV panel then lies shielded and to a lesser degree constitutes a aesthetic disturbance of the roof. The shape of the roof tiles may however be thus high, that additional measures have to be taken to have the PV panel lie in the roof at an effective height. Important however is that by removing the tiles the water-repellent layer is locally removed as well. Water control then has to be provided by the PV panel itself and by additional provisions, such as flashings, which have to be arranged in the transitional area between the PV panel and the tiled roof. This requires special care of the fitter, who will need the help from an expert roofer. Mistakes or inaccuracies cannot be ruled out, in which case leakage may occur.

The invention now has the objective to improve on this and to that end provides an assembly of a PV panel having a surface-area of several roof tiles, and a carrier for it, the carrier being provided with means for positioning in a tiled roof of a building and water-repellent connection to said tiled roof and extending like a plate underneath the PV panel. The plate-shaped carrier here forms a relatively thin singular, water-repellent replacement of the removed roof tiles. For the transitional area to the tiled roof no special measures have to be taken, so that fitting the assembly according to the invention is simple.

In case of an existing house the fitter, who may be the dweller himself, will simply be able to remove the roof tiles at a certain surface-area, attach the plate-shaped carrier and place the PV panel on it.

Preferably the plate is formed underneath the PV panel in order to form ventilation passages underneath the PV panel. Warm air which is formed under the PV panel can be discharged, so that the PV elements do not become too hot, which would otherwise decrease the efficiency. In case the tiled roof is inclined the ventilation passages are preferably substantially oriented in the upward direction of the tiled roof, so that for ventilation use is made of the rising of warm air, and a kind of chimney effect can arise.

Preferably the plate underneath the PV panel is provided with means for directed water drainage. The presence of a water flow between the PV panel and the plate-shaped carrier is no objection, because the plate-shaped carrier is watertight.

Preferably the plate is formed with profilings for guiding air and/or water under the PV panel. Said profilings preferably are elongated and continuous in order to promote the manageability by increasing the stiffness of the plate-shaped carrier.

Preferably the plate-shaped carrier is provided with support means for direct support of the PV panel, preferably at its edge. The support means are preferably formed here by a circumferential elevation or elevated strip, which may be a part of an elevated middle portion of the plate-shaped carrier. Thus the PV panel is kept as much as possible at a distance from the precipitation possibly flowing down the roof along the edges. The outer edges of the elevation here form a barrier for the water, so that it cannot end up in the space below the PV panel.

Here the elevated middle portion can in an advantageous manner be provided with the aforementioned profilings, in particular ribs, for keeping the lower side of the PV panel at a distance from the upper surface of the middle portion.

Preferably the plate-shaped carrier is locally provided with an accommodation space for a voltage converter which space is accessible from above. Said voltage converter is situated at the outer side of the plate-shaped carrier, as a result of which the otherwise usual provisions for supporting the voltage converter have become unnecessary. The accommodation space may in an advantageous manner be integrally formed as a recess in the upper surface of the aforementioned middle portion.

It is preferred here that the accommodation space is contiguous to the ventilation passages. As a result the heat generated by the voltage converter is discharged, which may mean an extension of the life span of the voltage converter. The ventilating air flows here may flow in between the lower side of the PV panel and the converter.

Preferably the PV panel is detachably placed on the carrier, so that replacement is possible. The plate-shaped carrier can be kept lying in the roof during its replacement, so that no special actions are required to prevent leakage.

The plate-shaped carrier can provide several functions, for instance by providing it with a layer of sound insulating material at the lower side of the plate.

The plate-shaped carrier may have the surface-area which approximates the surface-area of one common PV panel, but is also possible to use larger plate-shaped carriers, in particular those who have a surface area which can be compared to that of two PV panels.

The invention further relates to a plate-shaped carrier, suitable for use in an assembly according to the invention.

The invention will now be elucidated on the basis of a number of exemplary embodiments shown in the attached drawings, in which:
Figure 1 shows a top view inclined from below on a carrier plate for the assembly according to the invention;
Figure 2 shows a perspective view from above on an upper part of the carrier plate in the assembly according to the invention;
Figure 3 shows a view of the lower side of the carrier plate according to figures 1 and 2;
Figure 4 shows a perspective view inclined from below on an assembly according to the invention with PV panel;
Figures 5A-D show consecutive steps in the placing of the assembly according to the invention;
Figure 6 shows a schematic cross-section of an alternative embodiment of a carrier plate for an assembly according to the invention;
Figure 7 shows a cross-section of a longitudinal half of a further alternative embodiment of an assembly according to the invention; and
Figure 8 shows an isometric view on the assembly of figure 7, in disassembled situation, without foam strips.

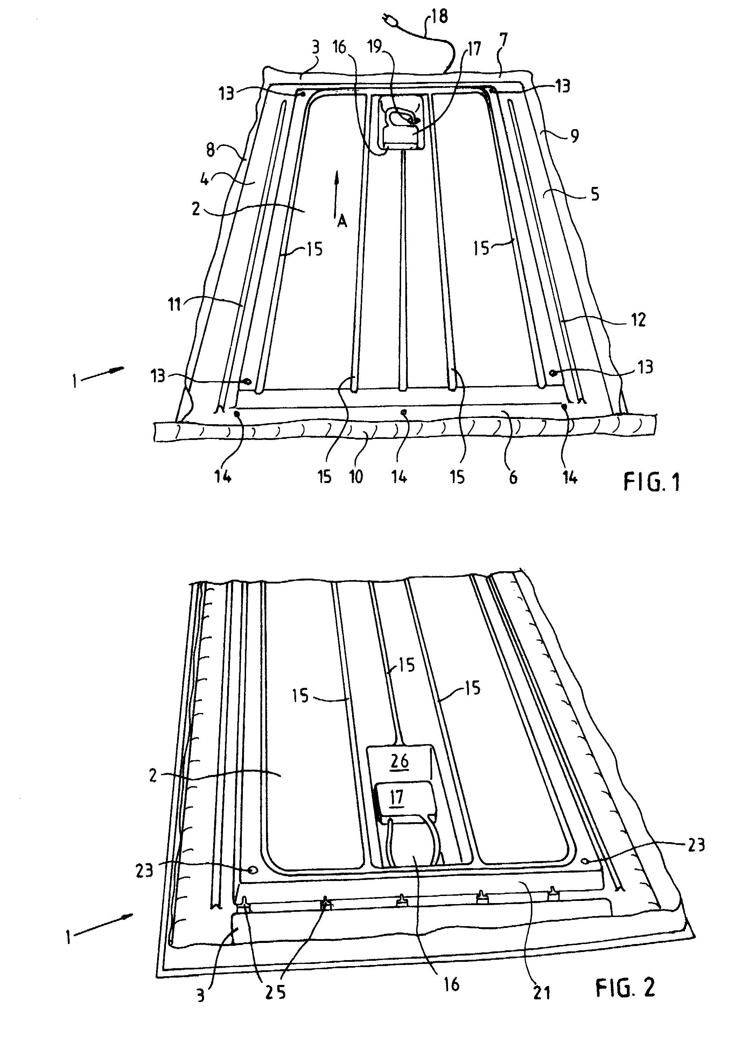

The carrier plate 1 shown in figure 1 in this example is formed from PE or PVC by means of vacuum moulding and has a thin wall thickness. The carrier plate 1 has an elevated plate-shaped middle portion 2, which at the upper end is bounded by an upper gutter 3, and on the left-hand side by a left-hand gutter 4, on the right-hand side by a right-hand gutter 5 and at the lower end by a bottom gutter 6.

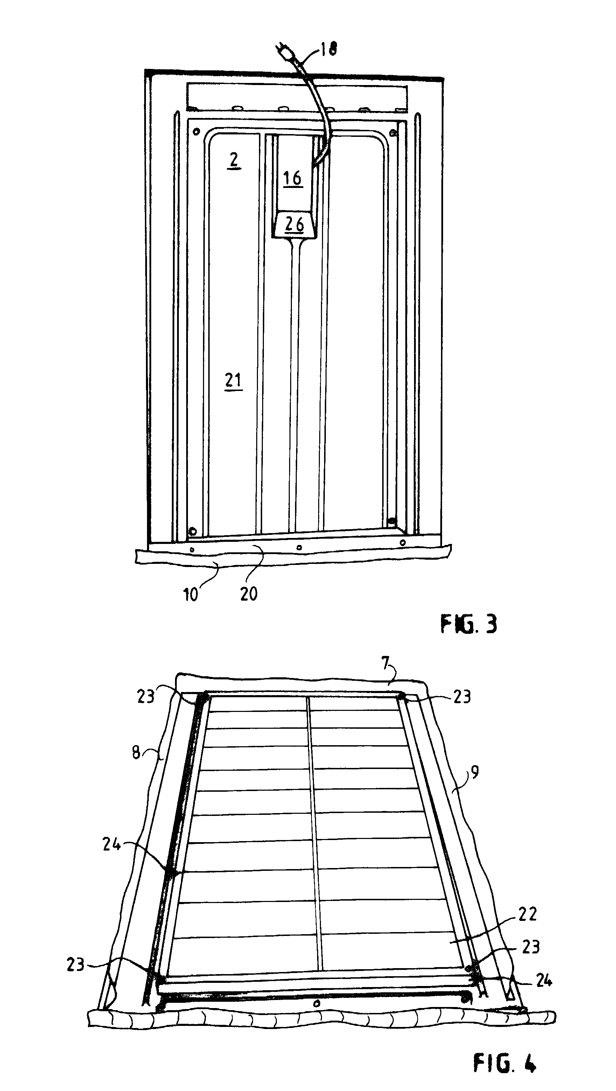

The gutters 3-6 are formed by a circumferential flange, the upper gutter 3 being upwardly bounded by a synthetic foam strip 7 attached to it, which can be pressed in, the left-hand gutter 4 being bounded by a same foam strip 8 and the right-hand gutter 5 by a same foam strip 9. The foam strips 7-9 form one continuous whole and keep snow from the adjacent space directly below the roof tiles connecting thereto. The bottom gutter 6 discharges freely: at the lower edge of the carrier plate 1 a cover flashing 10 is attached, with the help of an attachment strip 20, shown in figure 3. Instead of a cover flashing a strip may formed at the lower edge, which strip may have the shape of a series of roof tiles.

In the bottom of the left-hand gutter 4 and the right-hand gutter 5 raised ribs 11 and 12 are formed, for guiding the water from top to bottom and for increasing the stiffness of the carrier plate 1.

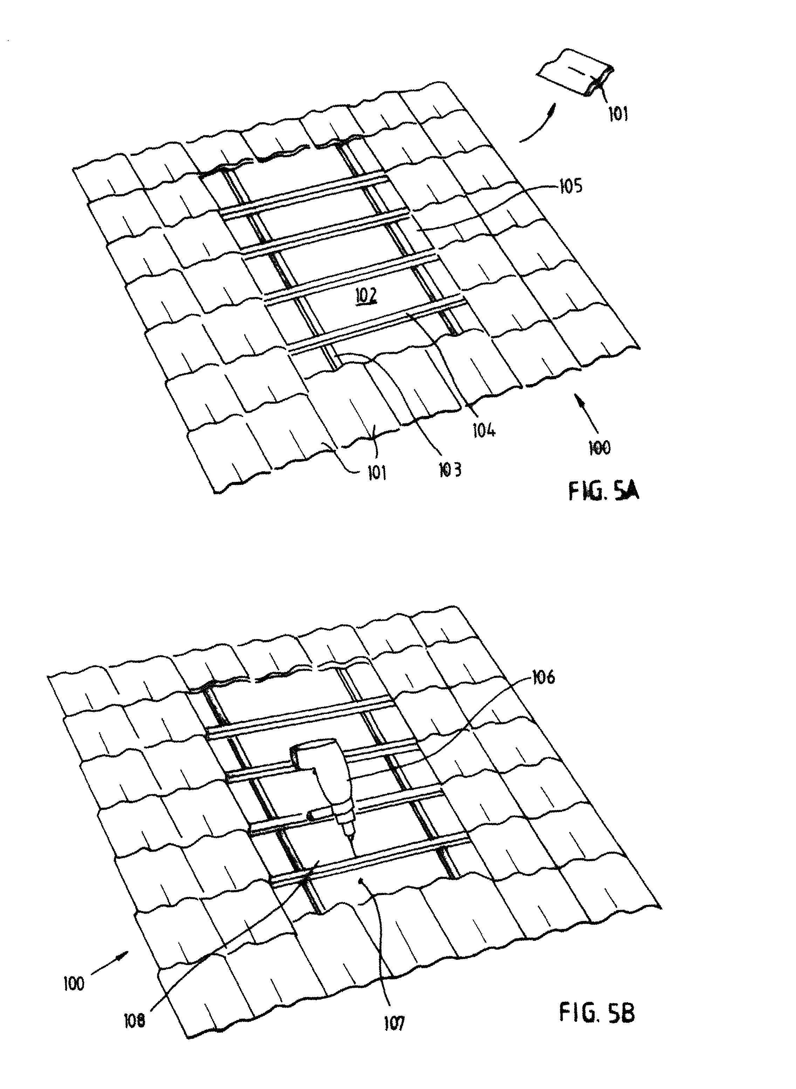

At the vertices the elevated portion 2 is provided with holes 13, for attaching the PV panel 22 shown in figure 4, by means of attachment holes 24 provided in the circumferential frame 23, through which attachment holes bolts that are not shown can be screwed in. In the holes 13 of the carrier plate 1 nuts may be accommodated to that end.

The elevated middle portion 2 is also provided with a number of grooves 15 extending from top to bottom and at the top also in horizontal direction, as well as with an integrally formed accommodation space 16, in which a voltage converter 17 is accommodated and in which also a junction box can be accommodated at the lower side of the PV panel. The voltage converter 17 extends with a cord 18 through a cord hole 19 in the accommodation space 16 to a wall socket situated below the roof, for discharging voltage generated by the PV panel from solar energy to the supply network.

In figure 2 the accommodation space 16 is shown more clearly. The accommodation space is shaped like rectangular tray, having an inclined lower side 26 for the discharge of water.

In case the PV panel 22 is placed on the elevated middle portion 2, an intermediate space is left free between the lower surface of the PV panel 22 and the upper surface of the elevated middle portion, so that the PV panel can be cooled at the lower side, wherein the heat generated there and in particular the heat generated in the voltage converter 17 as well, can be discharged rising (direction A). In this respect in the mounted situation a slit-shaped space is left at the lower edge and at the upper edge between the elevated portion 2 and the PV panel 22, so that ventilation and water discharge are ensured.

It will be understood that the grooves 15 could possibly be replaced by integrally formed, projecting ribs, which may then also fulfil a function in the directing of a water flow.

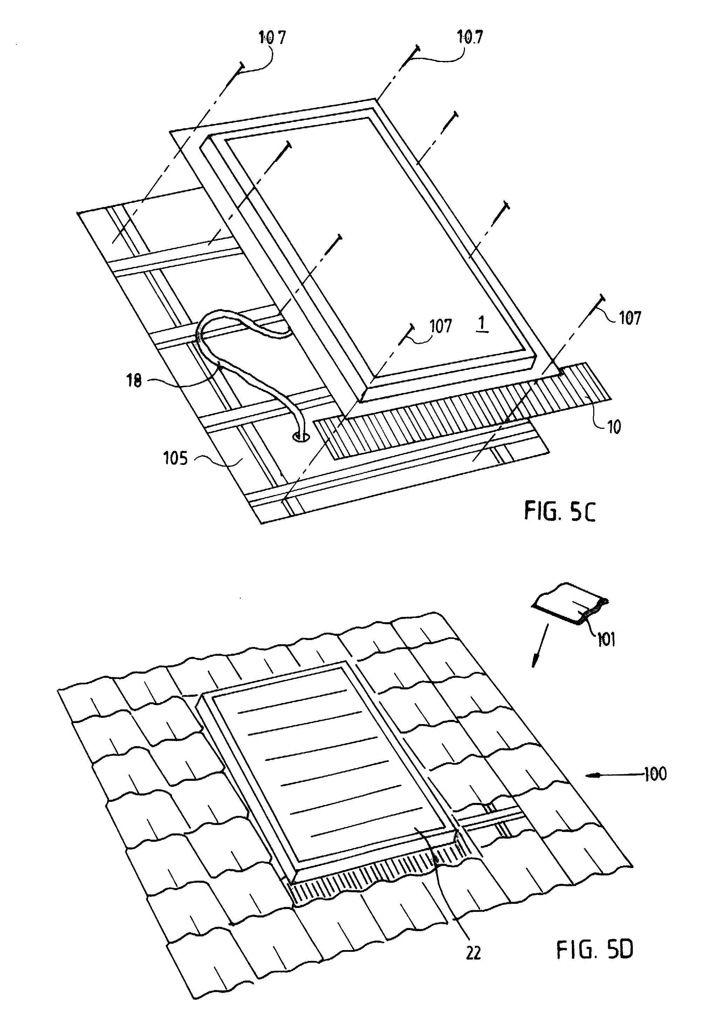

When attaching the assembly of the figures 1-4 in an existing tiled roof, as shown in figures 5A-D, a number of roof tiles 101 are removed first, so that the roof boarding 102 and the counter battens 101 and the battens 104 become visible. A rectangular space 105 has then become open in the tiled roof.

Subsequently a passage opening 107 for the electric cord is drilled in the roof boarding 102 with the help of a drill 106 and after that the carrier plate 1 with the cover flashing 10 attached to it is fixed to the roof construction, preferably the battens 104, with the help of screws 109. The carrier plate 1 is then supported by the battens 104. The cover flashing 10 is laid over the series of roof tiles 101 situated below it.

Subsequently the PV panel 22 is placed over and on the elevated middle portion 2 of the carrier plate 1, the frame 24 being supported on the edges of the elevated portion 2 at a number of locations.

The adapter at the lower side of the PV panel, which panel for instance may be a panel of the trademark Shell-Solar (registered trademark), fits in the accommodation space 16 adjacent to the voltage converter 17. Such a panel has dimensions of approximately 70 x 140 cm.

The carrier plate 1 here has dimensions of approximately 100 x 165 cm. The minimal height of the carrier plate is determined by the tray height necessary for the converter and the cord, in which also the shading action of the adjacent roof tiles has to be prevented.

After placing the PV panel 22 some roof tiles 101 can be placed back, along the upper edge and the side edges of the assembly according to the invention. The roof tiles along the upper edge are supported on the foam strip 7 and the roof tiles along both sides are supported on the foam strips 8 and 9. Water that flows down from above over the roof tiles 101, will then be able to flow from the roof tiles 101 situated at the upper edge into the gutter 3 and subsequently be stopped by the barrier surface 21 of the elevated middle portion 2, flow away sidewards and finally flow downwards through the gutters 4 and 5. The raised foam strips 8 and 9 prevent snow from ending up under the roof tiles. The ribs 11, 12 prevent the water flowing in the gutters 4 and 5 from flowing away in sideward direction. At the lower ends of the gutters 4 and 5 the water flows via the cover flashing 10, on the row of roof tiles 101 situated below it.

The support cams 25 at the upper edge of the elevated portion 2 form a stop for the series of roof tiles connecting to it in order to prevent them from sliding against the PV panel. The elevated (approximately 1.5 cm), integrally formed strip 27 keeps the lower edges of those roof tiles at level, in the absence of a batten there.

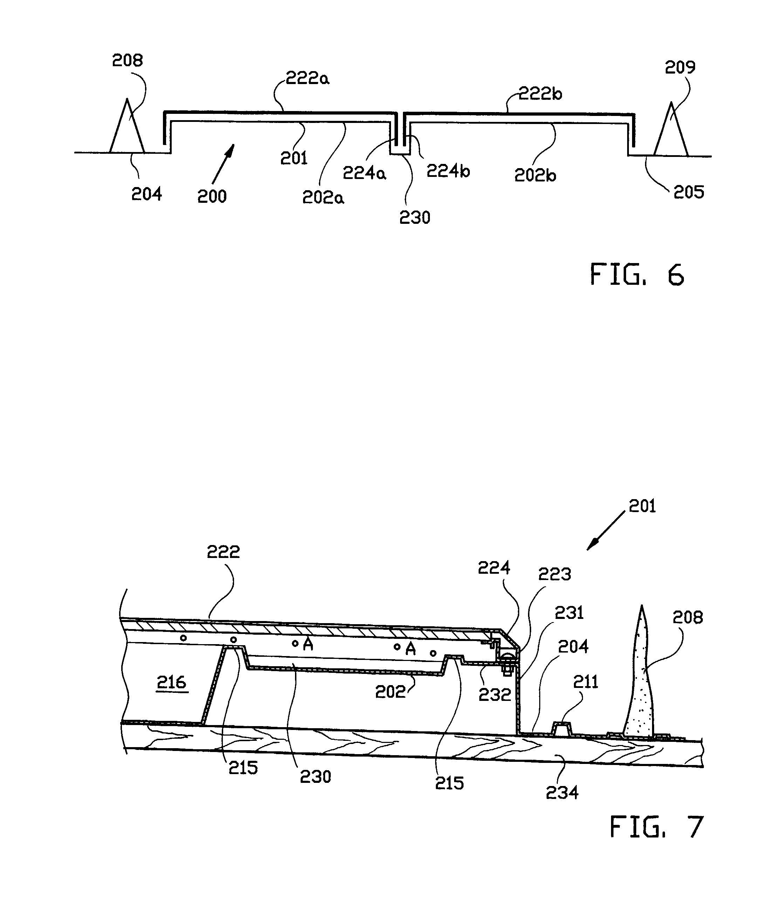

In figure 6 it is schematically shown that the carrier plate 201 can alternatively be designed double in direction of width, in which gutters 204, 205 are formed on both longitudinal edges, on the one hand bounded by the foam strips 208, 209, on the other hand bounded by the raised plate members 202a and 202b, which in the middle are separated from each other by a little gutter 230. The little gutter 230 makes it possible to place two panels next to each other, on the elevated plate members 202a and 202b, respectively, in which the adjacent frames 224a, b are accommodated in the little gutter 230. Thus several PV panels can be placed in a tiled roof in the manner according to the invention, without special measures having to be taken for the transitional construction between the PV panels one to the other.

The replacement of a PV panel takes place in a simple manner, by loosening its connection to the carrier plate and removing the panel concerned and to replace it by a new panel. Without the watertightness of the roof being altered during the action, the new panel can be picked up and placed.

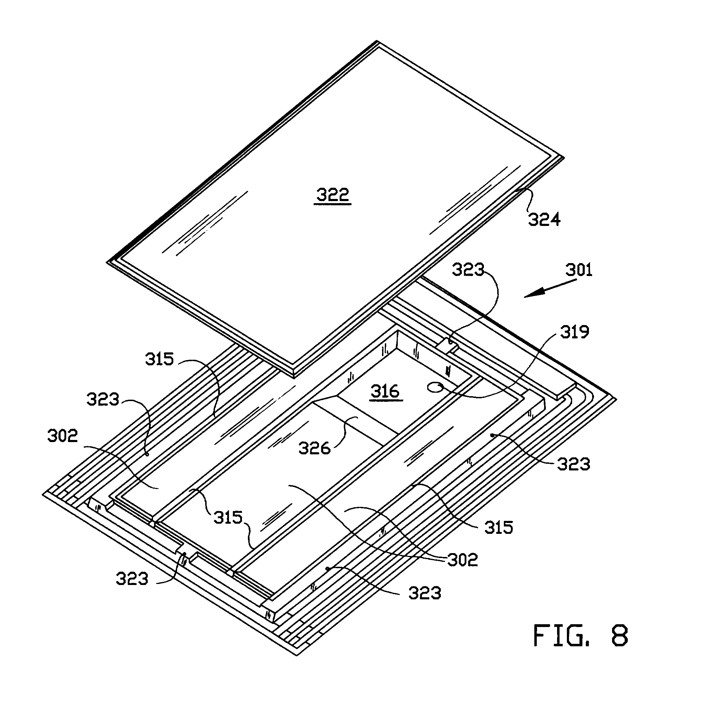

In figures 7 and 8 an alternative embodiment of the carrier plate 301 is shown which is laid on battens 334 and then extends with gutter 304 downwardly inclined along an inclined roof, a rib 311 ensuring guidance of a water flow and foam strip 308 again ensuring that snow is held back.

The carrier plate 301 has a circumferential raised edge 331, which to the inside changes into horizontal strip 332. With the help of bolts, situated near the vertices of the PV panel 322, the PV panel 322 is attached on the strip 332 with the circumferential frame 324. At the shown longitudinal edge of the carrier plate 301 the strip 332 has a constant height. At the upper and the lower side, however, it will be lowered between the vertices, for ventilation purposes.

The elevated middle portion 302 here has two ribs 315 extending in longitudinal direction. The local accommodation space 316 can be seen, which space will be able to house the converter and a length of cord. It can furthermore be seen that between the PV panel 322 and the carrier plate 301 a space is left open in which ventilation in direction A can take place.

Finally another transverse rib 330 can be seen which has a function in laterally near the lower edge discharging water flowing down over the elevated middle portion 302. Near the vertices further suitable discharge openings are left free between the PV panel 322 and the carrier plate 301 to that end.

It is noted that the elevated middle portion 302 can alternatively be replaced by a portion provided with ribs, which portion abuts the batten and is surrounded by elevated plate members for forming support means for the PV plate and for accommodating the converter.

## Claims

1. Assembly of a PV panel having a surface-area of several roof tiles, and a carrier for it, the carrier being provided with means for positioning in a tiled roof of a building and water-repellent connection to said tiled roof and extending like a plate underneath the PV panel.

2. Assembly according to claim 1, the plate underneath the PV panel being formed in order to form ventilation passages underneath the PV panel.

3. Assembly according to claim 2, the tiled roof being inclined and the ventilation passages being substantially oriented in the upward direction of the tiled roof.

4. Assembly according to claim 1, 2 or 3, the plate underneath the PV panel being provided with means for directed water drainage.

5. Assembly according to claim 3 or 4, the plate being formed with profilings for guiding air and/or water under the PV panel, preferably ribs.

6. Assembly according to claim 5, the profilings being elongated and continuous.

7. Assembly according to any one of the preceding claims, the plate-shaped carrier being locally provided with an accommodation space for a voltage converter which accommodation space is accessible from above and preferably is formed auto-dewatering, preferably by means of an oblique wall.

8. Assembly according to claim 7, when depending on claim 2, the accommodation space being contiguous to the ventilation passages.

9. Assembly according to any one of the preceding claims,the PV panel being detachably placed on the carrier.

10. Assembly according to any one of the preceding claims, the plate-shaped carrier being provided with a layer of sound-absorbent material at its lower side.

11. Assembly according to any one of the preceding claims, the plate-shaped carrier being made of a synthetic material, preferably PE or PVC.

12. Assembly according to any one of the preceding claims, in which outside of the circumference of the PV plate, the plate-shaped carrier is provided with means for guiding and drainage of water.

13. Assembly according to any one of the preceding claims, the plate-shaped carrier being provided with elevated support means for the edge of the PV panel and a circumferential flanged edge.

14. Assembly according to claim 13, the plate-shaped carrier also being provided with an integrally formed accommodation space for a converter, the accommodation space preferably being provided with a cord hole.

15. Assembly according to claim 13 or 14, the elevated support means being formed at a circumferential (barrier) strip of the carrier, the continuous ventilation passages being left free between the PV panel and the strip.

16. Assembly according to claim 15, the strip being a part of an elevated middle portion of the plate-shaped carrier, which is preferably provided with aforementioned profilings at its upper side.

17. Assembly according to claim 14 and 16, the accommodation space being formed as a recess in the upper side of the middle portion and preferably supporting the converter in order to leave a slit space between the converter and the PV panel.

18. Assembly according to any one of the preceding claims, the plate-shaped carrier being adapted for supporting at least two PV panels.

19. Plate-shaped carrier suitable for use in the assembly according to any one of the preceding claims.
